# EUROPÄISCHE PATENTSCHRIFT

(11) **EP 1 825 561 B1**
(45) Veröffentlichungstag und Bekanntmachung des Hinweises auf die Patenterteilung: **28.03.2012**
(21) Anmeldenummer: 05803270.7
(22) Anmeldetag: 14.11.2005
(51) Int. Cl.: H01Q 1/32, H01Q 1/22, H01Q 1/40, H01Q 1/42, H01Q 9/28, H01Q 19/24

(54) **ANTENNENANORDNUNG FÜR EINEN RADAR-TRANSCEIVER**
ANTENNA ASSEMBLY FOR A RADAR TRANSCEIVER
ENSEMBLE ANTENNE POUR EMETTEUR-RECEPTEUR RADAR

(30) Priorität: 09.12.2004 DE 102004059333
(43) Veröffentlichungstag der Anmeldung: 29.08.2007
(73) Patentinhaber: ROBERT BOSCH GMBH, 70442 Stuttgart (DE)
(72) Erfinder: VOIGTLÄNDER, Klaus, 73117 Wangen (DE)
(86) Internationale Anmeldenummer: PCT/EP2005/055951
(87) Internationale Veröffentlichungsnummer: WO 2006/061307

(56) Entgegenhaltungen:
- EP-A- 0 795 925
- EP-A- 1 475 858
- US-A- 6 052 098
- US-A1- 2005 104 795
- PATENT ABSTRACTS OF JAPAN Bd. 015, Nr. 241 (E-1080), 21. Juni 1991 (1991-06-21) -& JP 03 074908 A (TOYO COMMUN EQUIP CO LTD), 29. März 1991 (1991-03-29)
- PATENT ABSTRACTS OF JAPAN Bd. 014, Nr. 383 (E-0966), 17. August 1990 (1990-08-17) & JP 02 141007 A (MITSUBISHI ELECTRIC CORP), 30. Mai 1990 (1990-05-30)
- HARUN-UR RASHID A B M ET AL: "CHARACTERISTICS OF SI INTEGRATED ANTENNA FOR INTER-CHIP WIRELESS INTERCONNECTION" JAPANESE JOURNAL OF APPLIED PHYSICS, JAPAN SOCIETY OF APPLIED PHYSICS, TOKYO, JP, Bd. 43, Nr. 4B, April 2004 (2004-04), Seiten 2283-2287, XP001227750 ISSN: 0021-4922
- IN J-J ET AL: "INTEGRATED ANTENNAS ON SILICON SUBSTRATES FOR COMMUNICATION OVER FREE SPACE" IEEE ELECTRON DEVICE LETTERS, IEEE SERVICE CENTER, NEW YORK, NY, US, Bd. 25, Nr. 4, April 2004 (2004-04), Seiten 196-198, XP001190372 ISSN: 0741-3106

## Beschreibung

### Stand der Technik

Die Erfindung betrifft eine Antennenanordnung für einen Radar-Transceiver, insbesondere zur Abstands- und/oder Geschwindigkeitsermittlung im Umfeld von Kraftfahrzeugen nach dem Oberbegriff des Anspruchs 1.

Derartige Radar-Transceiver, das heißt Sende-/Empfängermodule, kommen im Mikrowellen- und Millimeterwellenbereich zur Ortung von Gegenständen im Raum oder zur Geschwindigkeitsbestimmung, insbesondere von Kraftfahrzeugen zum Einsatz. Solche Radar-Transceiver werden insbesondere für Fahrerassistenzsysteme verwendet, welche beispielsweise zur Bestimmung des Abstands eines vor einem Fahrzeug vorausfahrenden weiteren Fahrzeugs und zur Abstandsregelung eingesetzt werden. Dabei sendet ein solcher Radar-Transceiver zur Ortung von Gegenständen im Raum und zur Geschwindigkeitsbestimmung höchstfrequente Signale in Form elektromagnetischer Wellen aus, die vom Zielgegenstand reflektiert werden, und von dem Radar-Transceiver wieder empfangen und weiterverarbeitet werden. Nicht selten werden dabei mehrere dieser Radar-Transceiver zu einem Gesamtmodul verschaltet. Bei einem Einsatz in Automobilen kommen Frequenzen in einem Bereich von 76 bis 81 GHz zum Einsatz.

Aus der DE 103 00 955 A1 ist ein Radar-Transceiver für Mikrowellen- und Millimeterwellenanwendungen bekannt geworden, bei dem auf einen in mehreren Schichten aufgebauten Bauelement sowohl Sende- und Empfangseinheiten als auch eine Antenne angeordnet sind. Ein derartiger Schichtaufbau erfordert Verbindungen, die so ausgeführt scin müssen, daß eine Übertragung von höchstfrequenten IIF-Signalen möglich ist. Um solche HF-Übergänge einigermaßen verlustarm herstellen zu können, sind bei diesen Radar-Transceivern sehr hohe Anforderungen an die Fertigung zu stellen.

Aus der DE 196 48 203 A1 ist ein mehrstrahliges Kraftfahrzeug-Radarsystem bekannt geworden. Bei diesem Radarsystem sind die Sende- und Empfangseinheiten sowie die Antenne auf unterschiedlichen Trägern angeordnet.

(Aus der EP 0 795 925 A2 ist eine Antenenneinrichtung bekannt, bei welcher eine erste Treiberantenne als Patch-Antenne und eine parasitäre Antenne als Patch-Antenne vorgesehen sind, welche in einer Vorrichtung angeordnet sind, wobei die Vorrichtung eine Kapsel in Form eines Radoms aufweist, an welchem die parasitäre Patch-Antenne befestigt ist.

Aus der EP 1 475 858 A1 ist eine Antennenanordnung bekannt, bei welcher eine erste Dipolantenne und eine zweite parasitäre Dipolantenne an einem Gehäuse eines Mobiltelefons befestigt sind.)

Zur Erzeugung der in Kraftfahrzeugen oft verwendeten Frequenzen von 76 bis 81GHz werden sehr häufig Gunn-Oszillatoren eingesetzt. Des weiteren werden oft GaAs-MMIC's (monolithic microwave integrated circuits) verwendet. In jüngster Zeit wird als Werkstoff für derartige Chips auch SiGe eingesetzt. Mit diesern Werkstoff sind mittlerweile auch Grenzfrequenzen größer als 200 GIIz erreichbar. Derartige Chips werden üblicherweise in Flip-Chip-Technologie auf einen Träger beispielsweise aus Keramik, LTCC (low temperature cofired ceramic), eine Leiterplatte oder ein Softboard aufgebracht. Darüber binaus werden diese Chips auch durch Bonden verdrahtet. Auf dem Trägermaterial sind dann schr oft weitere Verteilnetzwerke, Bauelemente und auch Antennen angeordnet. Die Aufbau- und Verbindungstechnik ist hierbei toleranzbehaftet, schwer kontrollierbar und teuer. Sie weist des weiteren bei hoben Frequenzen schlechte elektrische Eigenschaften auf.

Zur Vermeidung dieser Nachteile ist in der nicht vorveröffentlichten Anmeklung der Anmelderin mit der Rollennummer 309373 ein Radar-Transceiver beschrieben, der nicht nur einen einfach herzustellenden Aufbau und kleine Baumaße aufweist, sondern insbesondere auch zur Bestückung auf an sich bekannten Schaltungsträgern, beispielsweise gewöhnlichen Leiterplatten, geeignet ist. An diesern Radar-Transceiver sind die Sonde- und Empfangseinheiten auf einem einzigen Chip in einer Ebene neheneinanderliegend angeordnet. In der Ebene des Chips ist des weiteren wenigstens eine Patch-Antenne angeordnet. Aufgrund der elektrisch wirksamen schichtdicke der SiGe-Chips, die im Bereich von 4µm bis 20µm, vorzugsweise bei 11 µm liegt, können mit an sich bekannten ratch-Antennen jedoch nur Bandbreiten von wenigen Promille erreicht werden. Der Chip selbst weist in den meisten Fällen eine Dicke von etwa 300µm auf.

Der Erfindung liegt deshalb die Aufgabe zugrunde, eine Antennenanordnung für einen Einchip-Radar-Transceiver mit insbesondere sehr dünner elektrisch wirksamer Oxidschicht zu vermitteln, die bei hohen Arbeitsfrequenzen, insbesondere in einem Bereich von 76 bis 81GHz eine große Reproduzierbarkeit, eine hohe Zuverlässigkeit und eine hohe Bandbreite ermöglicht. Darüber hinaus soll eine solche Antennenanordnung auf einfache und damit kostengünstige Weise herstellbar sein.

### Vorteile der Erfindung

Diese Aufgabe wird durch eine Antennenanordnung für einen Radar-Transceiver, insbesondere für Fahrerassistenzsysteme zur Abstands- und/oder Geschwindigkeitsermittlung im Umfeld von Kraftfahrzeugen mit den Merkmalen des Anspruchs 1 gelöst.

Grundidee der Erfindung ist es, auf Chips mit sehr dünnen elektrisch wirksamen Schichten, die auch die Sende-/Empfangseinheiten enthalten, eine Antennenanordnung vorzusehen, die statt Patch-Antennen gedruckte Dipole mit Paralleldrahtspeisung, das heißt differentieller Speiseleitung, verwendet. Die Antennenanordnung umfaßt dabei, einen ersten, auf dem Chip angeordneten Teil und einen in einem Abstand von dem ersten Teil an geordneten und an den ersten Teil strahlungsgekoppelten zweiten Teil. Durch diese Zweiteilung der Antenne wird eine vorteilhafte Vergrößerung der Bandbreite erreicht. Darüber hinaus sinkt der Strahlungswiderstand.

Erfindungsgemäß ist der zweite Teil der Antenne an einem Radom angeordnet. Dieses Radom bildet bevorzugt ein den Chip vollständig kapselndes Gehäuse.

Erfindungsgemäß ist der erste Teil ein erster Sende- und/oder Empfangsdipol und der zweite Teil ein zweiter Sende-und/oder Empfangsdipol.

Der erste Sende-/Empfangsdipol weist vorzugsweise zwei voneinander durch einen Zwischenraum getrennte Hälften auf. Er wird mit einer Paralleldrahtspeisung, das heißt mit einer differentiellen Speiseleitung, oder mit einer symmetrischen Speisung betrieben.

Gemäß einer vorteilhaften Ausführungsform weist der erste Sende- und/oder Empfangsdipol eine Länge von etwa einer Wellenlänge der abgestrahlten/empfangenen elektromagnetischen Strahlung auf.

Der zweite Sende- und/oder Empfangsdipol ist in diesem Fall ein nicht unterbrochener durchgängiger Dipol, der eine Länge von etwa einer halben Wellenlänge der abgestrahlten/empfangenen elektromagnetischen Strahlung aufweist.

Zur guten Feldkopplung ist vorgesehen, daß der zweite Sende- und/oder Empfangsdipol eine Breite aufweist, die der Breite des ersten Sende- und/oder Empfangsdipols im wesentlichen entspricht. Durch diese Anordnung ist eine weitere Reduktion des Wellenwiderstands erzielt. Die Speisung kann in diesem Falle mit zwei Mikrostreifenleitungen erfolgen.

Die Abmessungen der beiden Sende- und/oder Empfangsdipole sowie der Abstand zwischen dem ersten Sende- und/oder Empfangsdipol und dem zweiten Sende- und/oder Empfangsdipol hängt im wesentlichen von der verwendeten Frequenz ab, wobei der Abstand proportional zum Kehrwert der Frequenz variiert. Der Abstand zwischen dem ersten Sende- und/oder Empfangsdipol und dem zweiten Sende- und/oder Empfangsdipol beträgt in dem hier betrachteten Frequenzbereich von 76 bis 81GHz zwischen 200µm und 300µm, insbesondere 250µm.

Es versteht sich, daß die Erfindung nicht auf einen Frequenzbereich von 76 bis 81 GHz beschränkt ist, sondern auch auf andere Frequenzbereiche erstreckt werden kann, wobei in diesem Falle die Dimensionen frequenzabhängig in entsprechender Weise skaliert werden, das heißt, wenn beispielsweise der Abstand zwischen den beiden Sende- und/oder Empfangsdipolen sowie die Dimensionen der Antennen entsprechend angepaßt an die Frequenz verändert werden.

### Zeichnung

Weitere Vorteile und Merkmale der Erfindung sind Gegenstand der nachfolgenden Beschreibung sowie der zeichnerischen Darstellung von Ausführungsbeispielen.

In der Zeichnung zeigen:
Fig. 1 schematisch geschnitten ein Radar-Transceiver in Ein-Chip-Ausführung mit einer erfindungsgemäßen Antennenanordnung;
Fig. 2 die Anordnung von mehreren der in Fig. 1 dargestellten Radar-Transceivern;
Fig 3 ein weiteres Ausführungsbeispiel eines Radar-Transceivers in Ein-Chip-Ausführung zusammen mit einer erfindungsgemäßen Antennenanordnung, bei dem der Chip des Radar-Transceivers in Flip-Chip-Technik auf einem Substrat angeordnet ist;
Fig. 4 vier nebeneinander angeordnete, in Fig. 3 dargestellte Radar-Transceiver;
Fig. 5 ein weiteres Ausführungsbeispiel eines Radar-Transceivers in Ein-Chip-Ausführung zusammen mit einer erfindungsgemäßen Antennenanordnung, bei dem der Chip des Radar-Transceivers in Flip-Chip-Technik auf einem Substrat angeordnet ist;
Fig. 6 vier nebeneinander angeordnete, in Fig. 5 dargestellte Radar-Transceiver;
Fig. 7a schematisch eine Antennenanordnung für einen Radar-Transceiver gemäß der Erfindung;
Fig. 7b die in Fig. 7a dargestellte Antennenanordnung mit abgenommenem Radom;
Fig. 7c die in Fig. 7b dargestellte Antennenanordnung mit nicht dargestelltem zweiten Sende-/Empfangsdipol und
Fig. 8 schematisch die Anordnung des ersten Sende- und/oder Empfangsdipols und des zweiten Sende-/Empfangsdipols auf einem Chip.

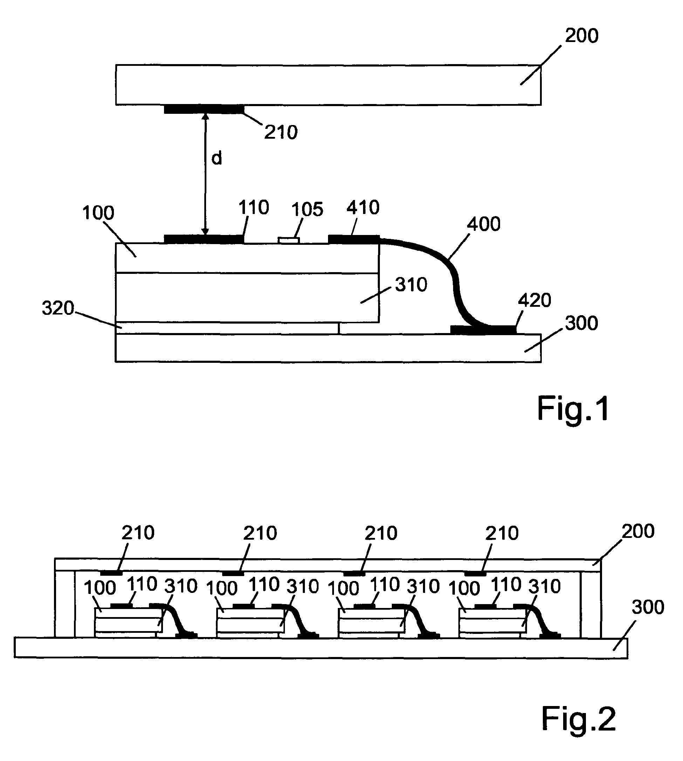

Bei einem in Fig. 1 dargestellten Radar-Transceiver sind auf einem SiGe-Chip 100 nicht nur sämtliche Sende-/Empfangseinrichtungen 105 des Transceivers angeordnet, sondern auch eine nachfolgend näher erläuterte Antennenanordnung. Auf dem Chip ist ein Dipol mit Paralleldrahtspeisung, das heißt differentieller Speiseleitung, vorgesehen. Um hohe Impedanzen erreichen zu können, wird der Dipol 110 in Spannungsspeisung betrieben. In einem Abstand d von dem ersten Teil der Antenne 110 ist an einem Radom 200 ein zweiter Teil der Antenne 210 angeordnet. Wird dieser zweite Teil der Antenne 210 etwa in einem Abstand von 250 µm an einem 300 µm dicken Radom angeordnet, sinkt der Wellenwiderstand auf etwa 800 Ohm. Dieses Radom wird gleichzeitig als Gehäuse genutzt, wobei der Chip 100 vollständig gekapselt wird, wie insbesondere aus Fig. 2 hervorgeht, wo vier derartige Radar-Transceiver nebeneinander auf einer Trägerplatte 300 angeordnet sind. Die aktive Mikrowellenschicht des SiGe-Chips 100, die etwa eine Dicke von 11 µm aufweist, ist auf einem Siliziumsubstrat 310 angeordnet, der über eine Zwischenschicht 320 - einem sogenannten Underfiller - auf einem Substrat 300 befestigt ist. Die gesamte Anordnung wird hier durch Bonddrähte 400, die eine elektrische Leitung zwischen Bondpatches 410, die auf dem SiGe-Chip 100 angeordnet sind, und Bondpatches 420, die auf dem Träger 300 angeordnet sind, vermittelt.

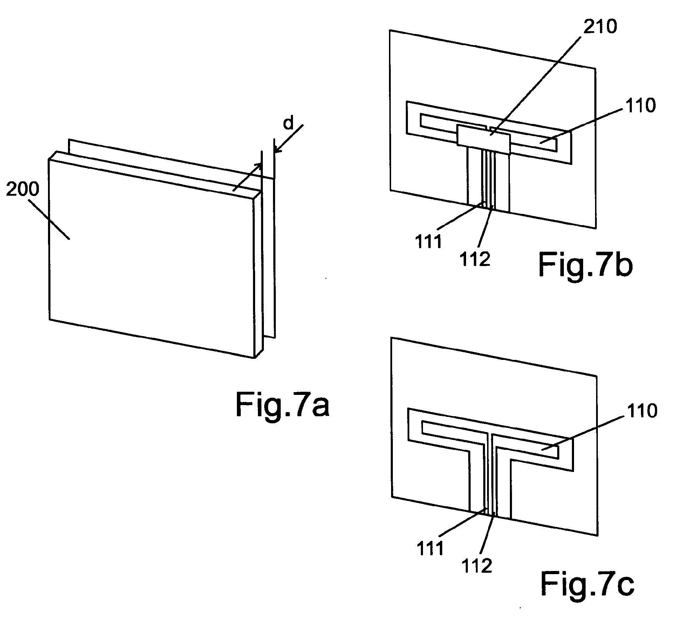

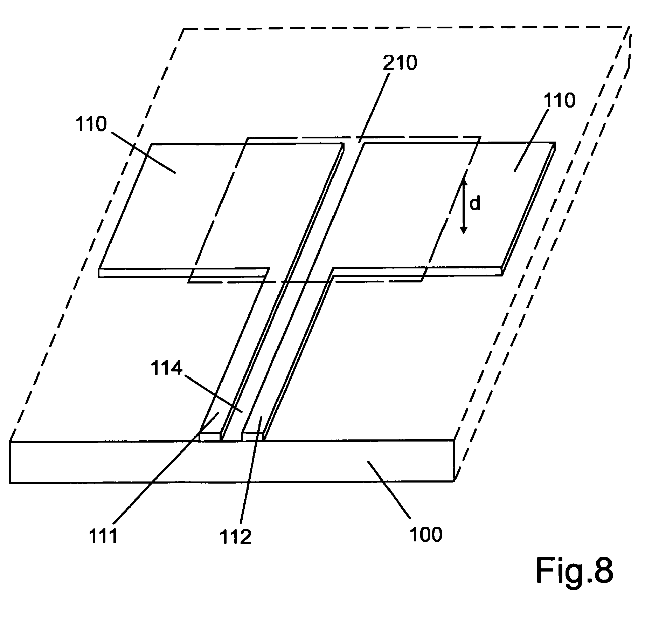

In Fig. 7 ist schematisch die Antennenanordnung dargestellt. Bei der in Fig. 7a schematisch gezeigten Darstellung überdeckt das Radom 200 die Antennenanordnung. Die zweite an dem Radom 200 angeordnete Antenne 210 weist hierbei den Abstand d von der ersten Antenne 110 auf (vergl. Fig. 7b). Die erste Antenne 110 ist durch eine Zweidrahtleitung 111, 112 gespeist (vergl Fig. 7c und Fig. 8). Die Speisung ist beispielsweise auf 50 Ohm ausgelegt. In erster Näherung ist sie frequenzunabhängig ausgelegt. Bei einer Dicke der Mikrowellenschicht von 11 µm beträgt die Breite der Leiterbahn bevorzugt etwa 20 µm. Der Zwischenraum ("Gap") 114 zwischen den beiden Leiterbahnen beträgt in diesem Falle ebenfalls etwa 20 µm. Beträgt die Schichtdicke der aktiven Mikrowellenschicht des Chips 100 nur beispielsweise 5 µm, wird eine Leiterbahnbreite der Leiterbahn 111, 112 von etwa 10 µm und ein Gap 114 von etwa 10 µm gewählt. Die Abstände können mit Hilfe von an sich bekannten Schaltungssimulatoren oder Feldsimulatoren oder auch meßtechnisch bestimmt werden.

Der an dem Radom 200 angeordnete zweite Teil der Antenne 210 ist, wie in Fig. 7b, 7c und Fig. 8 dargestellt, ein nicht unterbrochener Dipol mit einer Länge von einer halben Wellenlänge der gesendeten/empfangenen elektromagnetischen Wellen. Er weist zur guten Feldkopplung etwa die gleiche Breite auf wie der Ganzwellendipol auf dem SiGe-Chip 100. Durch diese Anordnung sinkt der Wellenwiderstand auf 100 Ohm. Es kann auf diese Weise eine Speisung des ersten Sende-/Empfangsdipols 110 mit 50 Ohm-Mikrostreifenleitungen erfolgen, deren Breite und Abstand bei einer Höhe des SiGe-Chips von 11µm jeweils 20µm betragen.

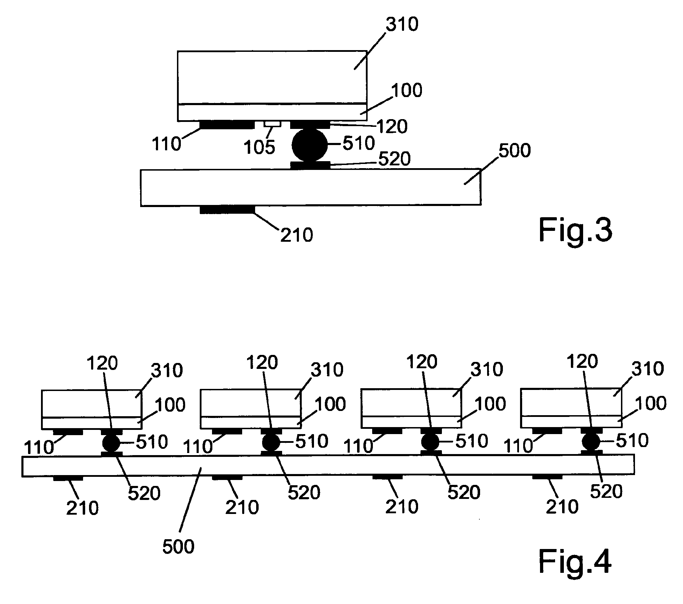

In Fig. 3 und 4 ist eine Anordnung des SiGe-Chips 100 in Flip-Chip-Technik dargestellt. Der SiGa-Chip 100 ist auf einem Siliziumträger 310 angeordnet. Statt der Bondpatches 410 weist er Kontaktflächen 120 auf, die in Flip-Chip-Technik durch einen Lötpunkt 510 auf Kontaktflächen 520 kontaktiert werden. Die Kontaktflächen 520 sind auf einem Träger 500 angeordnet. Auf dem SiGe-Chip 100 ist wiederum der erste Teil der Antenne 110, das heißt der erste Sende-/E-mpfangsdipol 110 angeordnet. Der zweite Teil der Antenne, das heißt der zweite Sende-/Empfangsdipol 210 ist in diesem Falle auf der dem SiGe-Chip 100 abgewandten Seite des Substrats 500 angeordnet. Das Substrat 500 muß aus einem Material bestehen, welches elektromagnetische Wellen sehr hoher Frequenzen im Mikrowellenbereich passieren läßt.

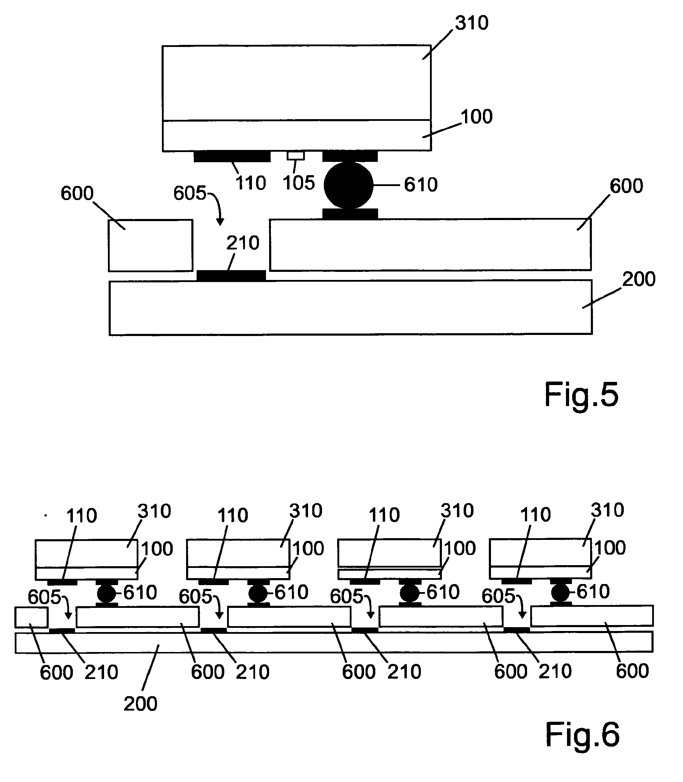

Bei einem weiteren, in Fig. 5 und 6 dargestellten Ausführungsbeispiel sind die gleichen Elemente wie bei den in Fig. 3 und 4 dargestellten Ausführungsbeispielen mit den gleichen Bezugszeichen versehen, so daß bezüglich deren Beschreibung auf das Vorstehende vollinhaltlich Bezug genommen wird. Im Unterschied zu dem in Fig. 3 und 4 dargestellten Ausführungsbeispiel ist bei dem in Fig. 5 und 6 dargestellten Ausführungsbeispiel ein Flip-Chip-Aufbau dargestellt, bei dem ein nicht mehr unbedingt für elektromagnetische Wellen sehr hoher Frequenzen durchlässiges und damit kostengünstigeres, mit Öffnungen 605 versehenes Niederfrequenzsubstrat 600 vorgesehen ist, auf dem Kontaktflächen 620 zur Flip-Chip-Anordnung des auf dem Siliziumträger 310 angeordneten SiGe-Chips 100 mittels Lötpunkten 610 vorgesehen sind. In den Öffnungen 605 des Niederfrequenzsubstrats 600 sind die zweiten Sende-/Empfangsdipole 210 angeordnet, beispielsweise an einem Radom 200 oder an einem Gehäuse.

Die Vorteile der vorstehend beschriebenen Antennenanordnung liegen in einer hohen Bandbreite, die durch eine Ganzwellenanregung mit differentieller Speisung realisiert wird. Ein weiterer Vorteil besteht darin, daß das Radom 200 als Gehäuskapselung verwendet werden kann, so daß die ganze Anordnung dicht und toleranzunempfindlich gegenüber Wasser/Tau ist. Darüber hinaus sind keine Übergänge vom Chip 100 auf das Substrat bei der Betriebsfrequenz (Hochfrequenz) erforderlich, sondern die Kontaktierung erfolgt über Bonddrähte oder durch Flip-Chip-Kontaktierung im Niederfrequenzbereich. Durch die Zwischenschicht 320, den sogenannten Underfiller, können Unterschiede in den Ausdehnungskoeffizienten ausgeglichen werden, so daß sich eine zuverlässige Befestigung des SiGe-Chips 100, der den eigentlichen Radar-Transceiver darstellt, auf dem Träger 300 ergibt.

Die Kontaktierung durch Bonddrähte 400 ist vor der Verkapselung realisierbar. Im Falle der in Fig. 3 bis 6 dargestellten Ausführungsbeispiele kann das Substrat zusätzlich Antennenstrukturen aufweisen. Darüber hinaus kann die Fläche unter der Antenne zur Erwärmung verwendet werden.

Die vorstehend beschriebene Antennenanordnung ist anhand eines SiGe-Chips 100 erläutert worden. Es versteht sich aber, daß die Erfindung nicht auf Chips ins Silizium-Germanium-Technik beschränkt ist, sondern auch bei SiGeC-Chips oder bei BiCMOS-Chips oder bei SiC-Chips zur Anwendung kommen kann.

## Patentansprüche

1. Antennenanordnung für einen Radar-Transceiver zur Abstands- und/oder Geschwindigkeitsermittlung im Umfeld von Kraftfahrzeugen,
wobei wenigstens eine Antenne auf einem Chip (100) angeordnet ist, der wenigstens einen Teil der Sende- und Empfangseinheiten eines Radar-Transceivers enthält,
wobei die wenigstens eine Antenne einen ersten, auf dem Chip angeordneten Teil und einen in einem Abstand von dem ersten Teil (110) angeordneten und an den ersten Teil strahlungsgekoppelten zweiten Teil (210) umfaßt,
wobei der zweite Teil (210) der Antenne an einem Radom (200) angeordnet ist, wobei das Radom (200) ein den Chip (100) vollständig kapselndes Gehäuse bildet,
**dadurch gekennzeichnet, dass** der erste Teil ein erster Sende- und/oder Empfangsdipol (110) ist,
daß der zweite Teil ein zweiter Sende- und/oder Empfangsdipols (210) ist,
und dass der erste Sende-und/oder Empfangsdipol ein Dipol mit differentieller Speiseleitung ist

2. Antennenanordnung nach Anspruch 1, **dadurch gekennzeichnet, daß** der erste Sende-/Empfangsdipol (110) zwei voneinander durch einen Zwischenraum getrennte Hälften aufweist.

3. Antennenanordnung nach einem der Ansprüche 1 oder 2, **dadurch gekennzeichnet, daß** der erste Sende- und/oder Empfangsdipol (110) eine Länge von etwa einer Wellenlänge der abgestrahlten/empfangenen elektromagnetischen Strahlung aufweist.

4. Antennenanordnung nach Anspruch 1, **dadurch gekennzeichnet, daß** der zweite Sende- und/oder Empfangsdipol (210) ein nicht unterbrochener durchgängiger Dipol oder Flächenstahler ist

5. Antennenanordnung nach Anspruch 4, **dadurch gekennzeichnet, daß** der zweite Sende- und/oder Empfangsdipol (210) eine Länge von etwa einer halben Wellenlänge der abgestrahlten/empfangenen elektromagnetischen Strahlung aufweist.

6. Antennenanordnung nach Anspruch 4 oder 5, **dadurch gekennzeichnet, daß** der zweite Sende- und/oder Empfangsdipol (210) eine Breite aufweist, die der Breite des ersten Sende- und/oder Empfangsdipols (110) im wesentlichen entspricht.

7. Antennenanordnung nach einem der Ansprüche 1 bis 6, **dadurch gekennzeichnet, daß** der Abstand zwischen dem ersten Sende- und/oder Empfangsdipol (110) und dem zweiten Sende- und/oder Empfangsdipol (210)im Frequenzbereich von 76 - 81GHz zwischen 200 und 300µm, insbesondere 250µm beträgt.

## Claims

1. Antenna arrangement for a radar transceiver for distance and/or speed determination in the area of motor vehicles, with at least one antenna being arranged on a chip (100) which contains at least some of the transmitting and receiving units of a radar transceiver,
with the at least one antenna comprising a first part, which is arranged on the chip, and a second part (210), which is arranged at a distance from the first part (110) and is coupled by radiation to the first part, with the second part (210) of the antenna being arranged on a Radome (200),
with the Radome (200) forming a housing which completely encapsulates the chip (100),
**characterized in that** the first part is a first transmitting and/or receiving dipole (110),
**in that** the second part is a second transmitting and/or receiving dipole (210),
and **in that** the first transmitting and/or receiving dipole is a dipole with a differential feed line.

2. Antenna arrangement according to Claim 1, **characterized in that** the transmitting/receiving dipole (110) has two halves which are separated from one another by an intermediate space.

3. Antenna arrangement according to one of Claims 1 or 2, **characterized in that** the first transmitting and/or receiving dipole (110) has a length of approximately one wavelength of the emitted/received electromagnetic radiation.

4. Antenna arrangement according to Claim 1, **characterized in that** the second transmitting and/or receiving dipole (210) is an uninterrupted continuous dipole or flat antenna element.

5. Antenna arrangement according to Claim 4, **characterized in that** the second transmitting and/or receiving dipole (210) has a length of approximately half the wavelength of the emitted/received electromagnetic radiation.

6. Antenna arrangement according to Claim 4 or 5, **characterized in that** the second transmitting and/or receiving dipole (210) has a width which corresponds substantially to the width of the first transmitting and/or receiving dipole (110).

7. Antenna arrangement according to one of Claims 1 to 6, **characterized in that** the distance between the first transmitting and/or receiving dipole (110) and the second transmitting and/or receiving dipole (210) is between 200 and 300 µm, in particular 250 µm, in the frequency range from 76 to 81 GHz.

## Revendications

1. Arrangement d'antenne pour un émetteur/récepteur radar destiné à déterminer la distance et/ou la vitesse dans l'environnement de véhicules automobiles, au moins une antenne étant disposée sur une puce électronique (100) qui contient au moins une partie des unités d'émission et de réception d'un émetteur/récepteur radar,
l'au moins une antenne comprenant une première partie disposée sur la puce électronique et une deuxième partie (210) disposée à une certaine distance de la première partie (110) et couplée par rayonnement à la première partie,
la deuxième partie (210) de l'antenne étant disposée sur un radôme (200),
le radôme (200) formant un boîtier qui encapsule entièrement la puce électronique (100),
**caractérisé en ce que** la première partie est un premier dipôle émetteur et/ou récepteur (110),
**en ce que** la deuxième partie est un deuxième dipôle émetteur et/ou récepteur (210),
et **en ce que** le premier dipôle émetteur et/ou récepteur est un dipôle avec une ligne d'alimentation différentielle.

2. Arrangement d'antenne selon la revendication 1, **caractérisé en ce que** le premier dipôle émetteur et/ou récepteur (110) présente deux moitiés séparées l'une de l'autre par un espace intermédiaire.

3. Arrangement d'antenne selon l'une des revendications 1 ou 2, **caractérisé en ce que** le premier dipôle émetteur et/ou récepteur (110) présente une longueur environ égale à une longueur d'onde du rayonnement électromagnétique émis/reçu.

4. Arrangement d'antenne selon la revendication 1, **caractérisé en ce que** le deuxième dipôle émetteur et/ou récepteur (210) est un dipôle constant ininterrompu ou un élément rayonnant plan.

5. Arrangement d'antenne selon la revendication 4, **caractérisé en ce que** le deuxième dipôle émetteur et/ou récepteur (210) présente une longueur environ égale à une demi-longueur d'onde du rayonnement électromagnétique émis/reçu.

6. Arrangement d'antenne selon la revendication 4 ou 5, **caractérisé en ce que** le deuxième dipôle émetteur et/ou récepteur (210) présente une largeur qui correspond pour l'essentiel à la largeur du premier dipôle émetteur et/ou récepteur (110).

7. Arrangement d'antenne selon l'une des revendications 1 à 6, **caractérisé en ce que** la distance entre le premier dipôle émetteur et/ou récepteur (110) et le deuxième dipôle émetteur et/ou récepteur (210) dans la plage de fréquences de 76 à 81 GHz est comprise entre 200 et 300 µm, notamment égale à 250 µm.
